(19) **Europäisches Patentamt European Patent Office Office européen des brevets**

(11) **EP 4 002 369 B1**

(12) **FASCICULE DE BREVET EUROPEEN**

(45) Date de publication et mention
de la délivrance du brevet:
**08.10.2025 Bulletin 2025/41**

(21) Numéro de dépôt: **21209142.5**

(22) Date de dépôt: **18.11.2021**

(51) Classification Internationale des Brevets (IPC):
*G11C 13/00* *(2006.01)*   *G11C 11/56* *(2006.01)*
*H10N 70/00* *(2023.01)*   *H10N 70/20* *(2023.01)*

(52) Classification Coopérative des Brevets (CPC):
**G11C 13/0004; G11C 11/5678; H10N 70/231;
H10N 70/826; H10N 70/828; H10N 70/8413;
H10N 70/8828**

(54) **DISPOSITIF MÉMOIRE À CHANGEMENT DE PHASE**

SPEICHERVORRICHTUNG MIT PHASENUMWANDLUNG

PHASE-CHANGING MEMORY DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.11.2020 FR 2012027**

(43) Date de publication de la demande:
**25.05.2022 Bulletin 2022/21**

(73) Titulaire: **Commissariat à l'Energie Atomique et
aux Energies
Alternatives
75015 Paris (FR)**

(72) Inventeurs:
- **NAVARRO, Gabriele
  38054 Grenoble Cedex 09 (FR)**
- **SABBIONE, Chiara
  38054 Grenoble Cedex 09 (FR)**

- **BOURGEOIS, Guillaume
  38054 Grenoble Cedex 09 (FR)**
- **SERRA, Anna-Lisa
  38054 Grenoble Cedex 09 (FR)**

(74) Mandataire: **Cabinet Beaumont
4, Place Robert Schuman
B.P. 1529
38025 Grenoble Cedex 1 (FR)**

(56) Documents cités:
**CN-A- 101 101 961    US-A1- 2007 200 108**

- **ZHANG WEI ET AL: "Unveiling the structural
  origin to control resistance drift in phase-change
  memory materials", MATERIALS TODAY,
  ELSEVIER, AMSTERDAM, NL, vol. 41, 13 August
  2020 (2020-08-13), pages 156 - 176,
  XP086396623, ISSN: 1369-7021, [retrieved on
  20200813], DOI: 10.1016/J.MATTOD.2020.07.016**

## Description

Domaine technique

La présente invention concerne de façon générale les mémoires non volatiles et plus particulièrement les mémoires à changement de phase (ou PCM de l'anglais Phase Change Memory) et leur structure.

Technique antérieure

Les mémoires à changement de phase ou PCM sont des mémoires non volatiles s'appuyant sur les propriétés des matériaux à changement de phase. Les matériaux à changement de phase ont, en effet, la capacité de basculer d'un état faiblement résistif à un état fortement résistif grâce à leurs échauffements. Les mémoires à changement de phase tirent profit du fait que les résistances électriques de la phase amorphe des matériaux à changement de phase et celles de la phase cristalline sont différentes afin de stocker des données.

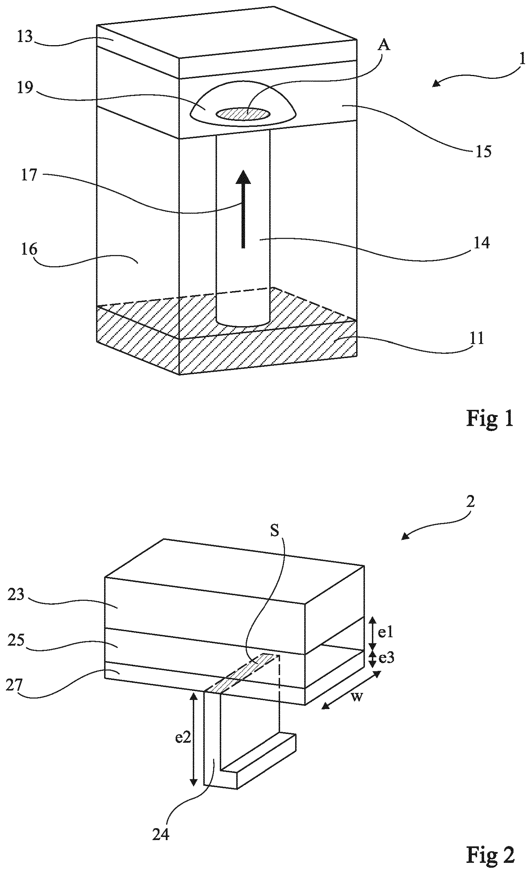

La figure 1 représente par une vue en perspective, partielle et schématique, un dispositif de mémoire à changement de phase 1.

Plus particulièrement, la figure 1 représente un dispositif 1 de mémoire à changement de phase comprenant une première électrode 13, qui correspond par exemple à une électrode haute, une couche 15 d'un matériau à changement de phase et une deuxième électrode 11, qui correspond par exemple à une électrode basse.

Le dispositif 1 comprend, optionnellement, un élément chauffant (heater) 14 entre la deuxième électrode 11 et la couche 15 du matériau à changement de phase.

Un problème du dispositif 1 illustré en figure 1 est qu'il demande un courant assez important afin d'être programmé, comme cela va maintenant être décrit plus en détail.

Le matériau à changement de phase a la capacité de basculer d'un état résistif à un état moins résistif, c'est-à-dire à un état faiblement résistif, et ce par l'échauffement de ce matériau sous l'effet d'impulsions électriques spécifiques appliquées par le moyen de ses deux électrodes 11 et 13.

Le basculement d'un état résistif à un état moins résistif correspond à une opération d'activation, dite SET, c'est-à-dire une opération d'écriture d'une valeur de donnée binaire, par exemple d'une valeur logique "1", et le basculement d'un état moins résistif à un état résistif correspond à une opération de désactivation, dite RESET, c'est-à-dire une opération d'écriture d'une valeur de donnée binaire opposée, par exemple d'une valeur logique "0".

Le volume de la couche 15 affecté par les changements de phase est restreint afin d'éviter l'utilisation d'un courant trop élevé. Pour cela, l'électrode 11, ou le cas échéant l'élément chauffant 14, n'est en contact de la couche 15 que sur une surface notée A et le volume affecté par les changements de phase correspond à un dôme 19 dont la base est supérieure ou égale à la surface A. Dans l'exemple de la figure 1, l'élément chauffant 14 a une forme de cylindre. Dans une variante, l'élément chauffant 14 a une forme de parallélépipède rectangle droit. Dans le cadre d'un dispositif comprenant un élément chauffant 14, l'élément chauffant 14 est, par exemple, entouré d'un isolant 16, de façon à augmenter la résistance thermique du dispositif et empêcher les dissipations thermiques par les bords de l'élément chauffant 14.

Pour effectuer l'opération de RESET, le dôme ou volume 19 est basculé dans un état résistif et pour effectuer l'opération de SET, le dôme ou volume 19 bascule dans un état faiblement résistif.

Chacune des opérations de SET et de RESET comprend par exemple une première transition dite électronique lors de laquelle une impulsion électrique relativement longue (quelques nanosecondes) et de faible intensité est appliquée à travers les électrodes 11 et 13. Cette première transition a pour but de faire basculer le volume 19 d'un état résistif à un état conducteur permettant le passage du courant.

Par la suite a lieu une deuxième transition dite "de phase" lors de laquelle le basculement du matériau à changement de phase d'un état résistif à un état moins résistif se déclenche pour une opération de SET ou le basculement du matériau à changement de phase d'un état moins résistif à un état résistif se déclenche pour une opération de RESET.

Lors de la transition de phase d'une opération de SET :

dans un premier temps la température du matériau à changement de phase atteint une température supérieure à la température de fusion ; et

dans un deuxième temps, la température diminue avec une vitesse relativement lente déclenchant la cristallisation du volume 19.

Si, pendant le deuxième temps, la vitesse n'est pas suffisamment lente, le volume 19 repasse dans un état résistif.

Le courant appliqué entre les deux électrodes 13 et 11 et la densité de courant sont reliés par la formule :

[Math 1]

$$I_{prog} = A.J_{prog}$$

dans laquelle $I_{prog}$ est le courant de programmation 17 appliqué entre les électrodes 11 et 13, $J_{prog}$ est la densité de courant de programmation, et A est, dans le mode de réalisation illustré en figure 1, la surface entre la couche 15 et l'électrode 11 ou, le cas échéant, entre la couche 15 et l'élément chauffant 14.

Ainsi, afin de permettre une réduction du courant de programmation, il serait souhaitable de réduire la surface A. Toutefois il reste un problème technique pour obtenir cet objectif tout en gardant la même plage de tension de fonctionnement du dispositif.

Le document US 2007/200108 décrit un nœud de stockage, une mémoire vive à changement de phase et les procédés de fabrication de celle-ci.

Le document Zhang Wei et al "Unveiling the structural origin to control resistance drift in phase-change memory materials", MATERIALS TODAY, ELSEVIER, AMSTERDAM, NL, vol. 41, 13 août 2020 (2020-08-13), pages 156-176, décrit le dévoilement de l'origine structurelle pour contrôler la dérive de résistance dans les matériaux de mémoire à changement de phase.

Le document CN 101101961 décrit une unité de mémoire à changement de phase avec matériau à changement de phase en boucle et son procédé de fabrication.

Résumé de l'invention

Il existe un besoin d'amélioration des dispositifs de mémoire à changement de phase.

Un mode de réalisation pallie tout ou partie des inconvénients des dispositifs de mémoire à changement de phase connus.

Un mode de réalisation selon la revendication indépendante 1 prévoit un dispositif de mémoire à changement de phase comprenant, entre des première et deuxième électrodes :

une première couche d'un matériau à changement de phase ; et
une deuxième couche à base de nitrure de germanium, en contact avec la première couche, le pourcentage atomique d'azote dans la deuxième couche étant compris entre 20 % et 35 %, et la deuxième couche étant traversée par un canal du matériau à changement de phase de la première couche.

Selon un mode de réalisation préféré selon la revendication dépendante 2, la première couche comprend une zone, en forme de dôme, changeant d'état en fonction de la densité de courant appliquée à travers la première couche.

Selon un mode de réalisation préféré selon la revendication dépendante 3, la largeur du canal est fonction du pourcentage en azote dans la deuxième couche.

Selon un mode de réalisation préféré selon la revendication dépendante 4, le dispositif comprend une troisième couche, d'un matériau à changement de phase, entre la deuxième couche et la deuxième électrode.

Selon un mode de réalisation préféré selon la revendication dépendante 5, la troisième couche comprend du germanium, de l'antimoine et du tellure.

Selon un mode de réalisation préféré selon la revendication dépendante 6 :

la deuxième électrode est en contact avec la deuxième couche de sorte que le canal est en contact de la deuxième électrode sur une surface déterminée par les dimensions du canal ; ou
un élément chauffant est en contact avec la deuxième couche de sorte que le canal est en contact de l'élément chauffant sur une surface déterminée par les dimensions du canal.

Selon un mode de réalisation préféré selon la revendication dépendante 7, le matériau à changement de phase est à base de germanium, d'antimoine et de tellure.

Selon un mode de réalisation préféré selon la revendication dépendante 8, la deuxième couche a une épaisseur comprise entre 2 nm et 30 nm, par exemple, comprise entre 3 nm et 25 nm.

Selon un mode de réalisation préféré selon la revendication dépendante 9, le dispositif comprend une quatrième couche à base de nitrure de germanium, entre la première électrode et la première couche.

Selon un mode de réalisation préféré selon la revendication dépendante 10, la deuxième couche comprend plusieurs sous-couches, et chaque sous-couche de la deuxième couche a un pourcentage en azote différent des pourcentages en azote des autres sous-couches de la deuxième couche.

Selon un mode de réalisation préféré selon la revendication dépendante 11, la deuxième couche comprend au moins une sous-couche intermédiaire entre deux autres des sous-couches, le pourcentage d'azote de la sous-couche intermédiaire étant supérieur au pourcentage d'azote des autres sous-couches.

Un mode de réalisation préféré selon la revendication dépendante 12, prévoit un système comprenant un ou plusieurs dispositifs tels de décrits, organisés en matrice, et une unité de programmation.

Un mode de réalisation selon la revendication indépendante 13 prévoit un procédé de fabrication d'un dispositif tel que décrit comprenant :

la formation de la première et de la deuxième couche ; et
une opération d'initialisation formant le canal dans la deuxième couche.

Selon un mode de réalisation préféré selon la revendication dépendante 14, l'étape d'initialisation est réalisée à des intensités de courant comprises entre 1 μA et 1,5 mA, par exemple entre 100 μA et 1,2 mA.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, par une vue en perspective, partielle et schématique, un dispositif de mémoire à changement de phase ;

la figure 2 est une vue en perspective, partielle et schématique, d'un mode de réalisation d'un dispositif à changement de phase ;

la figure 3 est un graphique représentant des exemples de la relation entre la résistance électrique d'une couche en nitrure de germanium et la concentration en azote dans cette même couche ;

la figure 4 est un graphique représentant des exemples de la relation entre la tension de rupture d'une couche en nitrure de germanium et la concentration en azote dans cette même couche ;

la figure 5 est un schéma bloc illustrant la programmation des phases d'initialisation, d'activation et de désactivation d'un matériau à changement de phase ;

la figure 6 est une vue en coupe, partielle et schématique, du dispositif illustré en figure 2 ;

la figure 7 est une vue en coupe, partielle et schématique, d'une variante de réalisation du dispositif illustré en figures 2 et 6 ;

la figure 8 est une vue en coupe, partielle et schématique, d'une autre variante de réalisation du dispositif illustré en figures 2 et 6 ;

la figure 9 est une vue en coupe, partielle et schématique, d'encore une autre variante de réalisation du dispositif illustré en figures 2 et 6 ;

la figure 10 est un schéma bloc illustrant un système de mémoire à changement de phase ;

la figure 11 représente un mode de réalisation de l'évolution de la densité de courant dans les dispositifs illustrés en figures 2 et 6 à 9 ;

la figure 12 représente un autre mode de réalisation de l'évolution de la densité de courant dans les dispositifs illustrés en figures 2 et 6 à 9 ;

la figure 13 représente un autre mode de réalisation de l'évolution de la densité de courant dans les dispositifs illustrés en figures 2 et 6 à 9 ;

la figure 14 représente un autre mode de réalisation de l'évolution de la densité de courant dans les dispositifs illustrés en figures 2 et 6 à 9 ;

la figure 15 représente un autre mode de réalisation de l'évolution de la densité de courant dans les dispositifs illustrés en figures 2 et 6 à 9 ; et

la figure 16 représente des vues en coupe, sous rayons X, du dispositif illustré en figure 6.

## Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seuls les matériaux constituant les mémoires à changement de phase ont été détaillés. Les mémoires à changement de phase décrites peuvent être reliées à des circuits intégrés usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

La figure 2 est une vue en perspective, partielle et schématique, d'un mode de réalisation d'un dispositif à changement de phase.

Le dispositif 2 comprend une première électrode 23, un élément chauffant 24 optionnel et une couche PCM 25 d'un matériau à changement de phase. Le dispositif 2 comprend, en outre, une couche GeN 27 dans laquelle un ou plusieurs filaments sont créés par un phénomène dit de rupture (breakdown).

Le matériau à changement de phase est, par exemple, un matériau GST, c'est-à-dire un matériau composé de germanium (Ge), d'antimoine (Sb) et de tellure (Te).

L'élément chauffant 24 est, par exemple, en tungstène ou en un alliage à base de titane ou de tantale.

Le dispositif 2 comprend, par exemple, une deuxième électrode, ou électrode basse, (non représentée en figure 2) en contact avec la couche GeN 27 dans le cas où il n'y a pas d'élément chauffant 24 ou, dans le cas contraire, en contact avec l'élément chauffant 24.

Les deux électrodes sont, par exemple, métalliques.

L'élément chauffant 24 est, par exemple, entouré d'un isolant (non représenté en figure 2), généralement de la silice (SiO2) ou du nitrure de silicium (SiN) de façon à augmenter la résistance thermique du dispositif et empêcher les dissipations thermiques par les bords de l'élément chauffant 24.

La couche PCM 25 a, par exemple, une épaisseur e1 comprise entre 10 nm et 200 nm et égale, par exemple, à environ 50 nm. Les couches PCM 25 et GeN 27 ont, par exemple, une largeur w comprise entre 3 nm et 500 nm et égale, par exemple, à environ 50 nm. En figure 2, l'élément chauffant 24 a été représenté coudé sous forme d'un "L". Toutefois, dans d'autres modes de réalisation, il peut être droit sans coude. En outre, en figure 2, l'élément chauffant 24 s'étend sur toute la largeur w des couches PCM 25 et GeN 27. Dans encore d'autres modes de réalisation, l'élément chauffant 24 peut être moins large que les couches PCM 25 et GeN 27. L'élément chauffant 24 a, par exemple, une épaisseur e2 comprise entre 1 nm et 50 nm et égale, par exemple, à environ 5 nm.

Dans l'exemple de la figure 2, la couche GeN 27 est située entre la couche PCM 25 et l'électrode basse ou, le cas échéant, entre la couche PCM 25 et l'élément chauffant 24. La couche GeN 27 est composée d'un matériau à base de nitrure de germanium (GeN) dans laquelle un filament s'étend de la face inférieure de la couche GeN 27 à la face supérieure de la couche GeN 27. La couche GeN 27 est, par exemple, composée uniquement de nitrure de germanium dopé, au maximum à 35 % (pourcentage atomique), avec du bore, de l'oxygène, de l'arsenic, du carbone ou du silicium ou une combinaison de toute ou partie ces dopants.

L'élément chauffant 24 ou, le cas échéant l'électrode basse, est, par exemple, en contact avec la couche GeN 27 sur une surface S.

Selon un mode de réalisation, le filament est créé lors d'une étape, en début de vie du dispositif 2, dite d'initialisation ("forming" en anglais) lors de laquelle une tension maximale est appliquée au dispositif 2. Dès lors que cette tension atteint une tension de rupture, le filament est créé dans la couche GeN 27. Cette étape d'initialisation est, par exemple, réalisée en même temps que la transition électronique et n'est pas répétée par la suite entre les cycles d'écriture du dispositif.

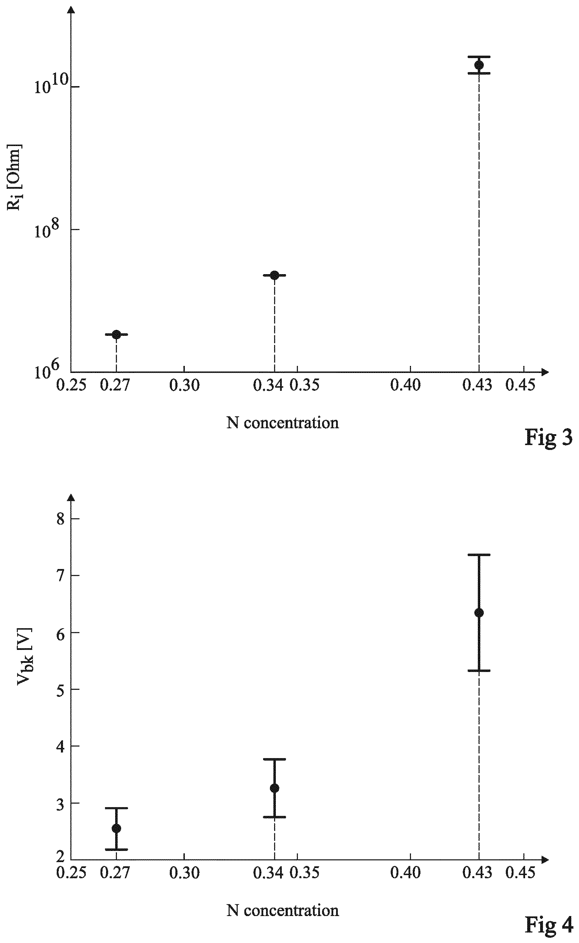

Le pourcentage en azote dans la couche GeN 27 est choisi en fonction de la tension de rupture souhaitée pour le matériau et de la résistance électrique souhaitée pour ce même matériau. Le pourcentage en azote dans la couche GeN 27 sera décrit plus en détail ci-après en relation avec les figures 3 et 4. La couche GeN 27 a une épaisseur e3 choisie, par exemple, de sorte que la tension de rupture soit suffisamment faible. L'épaisseur e3 de la couche GeN 27 est alors, par exemple, comprise entre 2 nm et 30 nm, dans certains exemples, comprise entre 8 nm et 12 nm, et dans d'autres exemples égale à environ 10 nm.

Lors de l'étape d'initialisation, et à la suite de la création du filament, une partie du matériau à changement de phase de la couche PCM 25 vient remplir l'intérieur du filament. Ainsi, la couche GeN 27 comprend un canal composé du matériau à changement de phase. Par ailleurs, ce canal présente une section, par exemple, comprise entre 5 nm et 15 nm, et, dans certains exemples, égale à environ 10 nm.

Le courant et la densité de courant traversant le dispositif 2 sont alors reliés par la surface A, correspondant à l'aire de contact entre le filament formé et l'élément chauffant 24 ou, le cas échéant, entre le filament formé et l'électrode basse. La surface A correspond ainsi à une partie de la surface S et est inférieure à celle-ci.

Un avantage qui apparaît de la présence d'une couche GeN 27 comprenant un filament s'étendant entre la couche du matériau à changement de phase et l'électrode basse, est que la surface A est réduite par rapport à la surface de contact d'une couche d'un matériau à changement de phase sur et en contact avec une électrode basse ou, le cas échéant avec l'élément chauffant 24. Cela engendre qu'une valeur de densité de courant peut être obtenue avec un courant de programmation plus faible.

Un avantage de la présence d'une couche de nitrure de germanium entre la couche du matériau à changement de phase et l'électrode basse, est que le nitrure de germanium a une plus grande compatibilité chimique et physique avec les matériaux chalcogénures que les oxydes, usuellement utilisés comme couche créatrice de filament.

Il est, par exemple, souhaitable d'avoir une tension de rupture de la couche GeN 27 suffisamment faible et ne dépassant pas la tension permis par la technologique, par exemple, de l'ordre de 2 V à 4 V, et une résistance du filament relativement faible en comparaison avec la résistance présentée par le basculement d'état du matériau à changement de phase. Les éléments principaux permettant d'influer sur ces valeurs sont l'épaisseur e3 de la couche GeN 27 et le pourcentage en azote dans la couche GeN 27. L'épaisseur e3 de la couche GeN 27 permet, notamment lorsqu'elle diminue, de diminuer la résistance.

La figure 3 est un graphique représentant la relation entre la résistance électrique du matériau de la couche GeN 27 et la concentration en azote du matériau de cette même couche. La résistance électrique du matériau de la couche GeN 27 a, dans cet exemple, été mesurée pour des couches GeN 27 présentant une épaisseur e3 de 10 nm.

En figure 3, un pourcentage en azote de 27 % dans la couche GeN 27 conduit à une résistance de l'ordre de $5.10^6$ $\Omega$, un pourcentage en azote de 34 % dans la couche GeN 27 conduit à une résistance de l'ordre de $5.10^7$ $\Omega$ et un pourcentage en azote de 43 % dans la couche GeN 27 conduit à une résistance de l'ordre de $5.10^{10}$ $\Omega$. Ainsi, plus la quantité d'azote augmente, plus la résistance de la couche GeN 27 augmente.

La figure 4 est un graphique représentant la relation entre la tension de rupture du matériau de la couche GeN 27 et la concentration en azote dans le matériau de cette même couche.

En figure 4, un pourcentage en azote de 27 % dans la couche GeN 27 conduit à une tension de rupture de l'ordre de 2,5 V, un pourcentage en azote de 34 % dans la couche GeN 27 conduit à une tension de rupture de l'ordre de 3,5 V et un pourcentage en azote de 43 % dans la couche GeN 27 conduit à une tension de rupture de l'ordre de 6,5 V. Ainsi, plus la quantité d'azote augmente, plus la tension de rupture de la couche GeN 27 augmente. La tension de rupture de la couche GeN 27 a, dans cet exemple, été mesurée pour des couches GeN 27 présentant une épaisseur de 10 nm.

Selon un mode de réalisation, le pourcentage en azote est compris entre 25 % et 35 %. Dans cette gamme de valeurs, le matériau de la couche GeN 27 présente une stabilité thermique améliorée lors de la transition électronique, de la rupture et des cycles d'écriture. Toujours dans cette gamme, la tension de rupture est suffisamment faible et la fenêtre mémoire, correspondant au rapport de la résistance électrique de matériau à changement de phase dans son état résistif et de la résistance électrique du matériau à changement de phase dans son état moins résistif, est suffisamment élevée pour ne pas réduire la fenêtre mémoire.

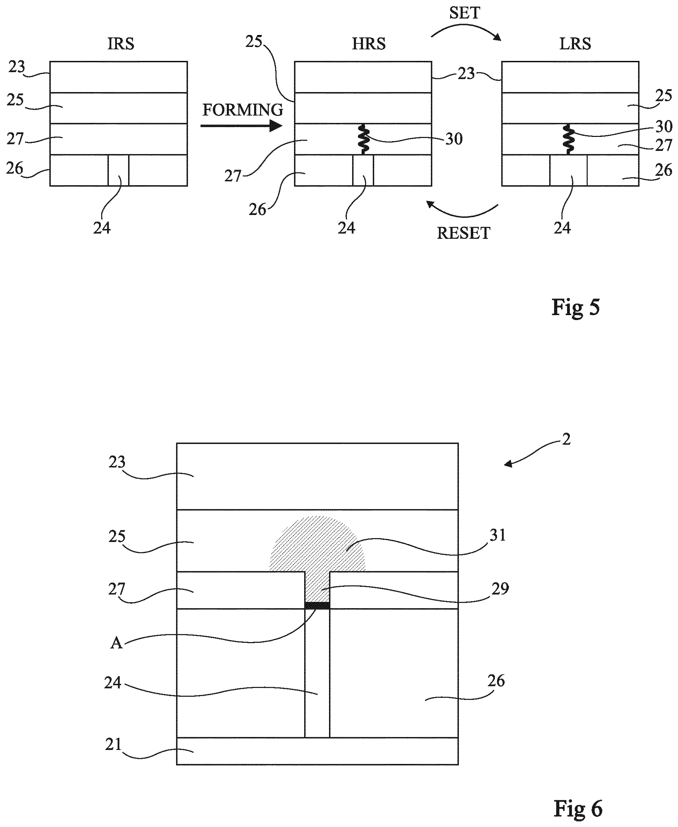

La figure 5 est un schéma bloc illustrant les opérations d'initialisation, d'activation (SET) et de désactivation (RESET) du matériau à changement de phase des couches GeN 27 et PCM 25. En figure 5, l'élément chauffant 24 est, par exemple, entouré d'une matrice isolante 26.

La structure du matériau à changement de phase, du dispositif 2 illustré en figure 2, évolue dans le temps en fonction de l'évolution de la température imposée au dispositif 2.

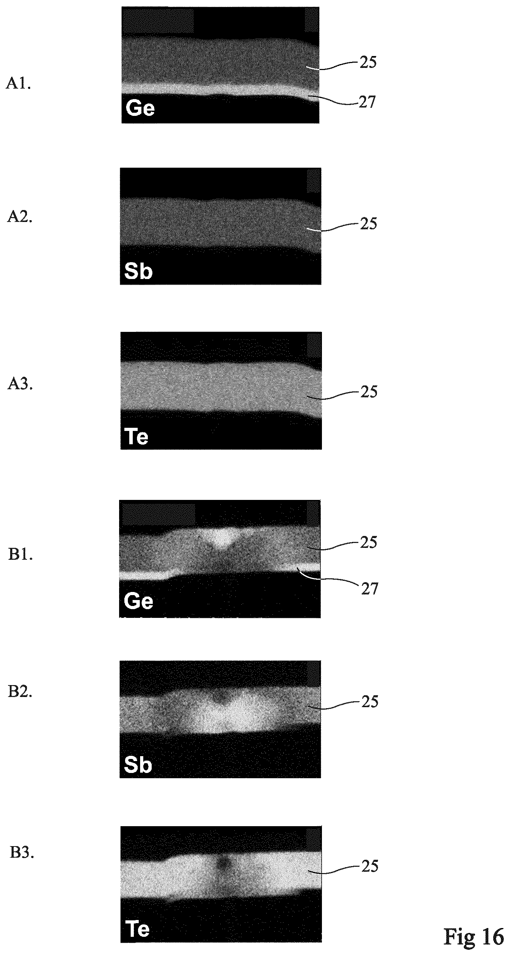

Tel que cela a été décrit en relation avec la figure 1, le matériau à changement de phase du dispositif 2 est, avant l'étape d'initialisation, dans un état initial résistif (IRS, Initial Resistive State). Le dispositif 2 subit ensuite l'initialisation (FORMING), lors de laquelle des impulsions rapides sont appliquées aux couches 25 et 27 afin qu'un filament soit créé à l'intérieur de la couche GeN 27. Lors de cette initialisation, le matériau à changement de phase présent dans la couche 25 est liquéfié et remplit l'intérieur du filament, précédemment créé, pour former un canal 30. Pendant cette étape d'initialisation, le courant appliqué à travers le dispositif est, par exemple, limité comme cela sera décrit plus en détail en relation avec la figure 16.

Selon la vitesse de refroidissement du dispositif, le matériau à changement de phase de la couche 25 et du canal 30 va, ensuite, prend un état soit résistif ou amorphe conducteur (HRS, High Resistive State) soit moins résistif (LRS, Low Resistive State). Dans la figue 5, l'exemple du passage vers un état résistif est illustré.

Le matériau à changement de phase, alors qu'il est dans un état à forte résistance (HRS), peut évoluer dans un état à faible résistance (LRS) lors d'une opération de SET. A l'inverse, le matériau à changement de phase, alors qu'il est dans un état à faible résistance (LRS), peut évoluer dans un état à forte résistance (HRS) lors d'une opération de RESET. Le stockage de données dans une mémoire à changement de phase se base sur des cycles d'écriture (SET et RESET) au cours desquels le canal 30 est conservé.

Dans la présente description, l'état dit "résistif" peut, à titre d'exemple, être un état amorphe, c'est-à-dire un état désordonné ayant une résistance électrique élevée et l'état dit "moins résistif" ou "faiblement résistif" peut, à titre d'exemple, être un état cristallin ou partiellement cristallin, c'est-à-dire un état ordonné ayant une résistance électrique moindre.

La figure 6 est une vue en coupe, partielle et schématique, du dispositif 2 illustré en figure 2.

Selon le mode de réalisation illustré en figure 6, en plus des éléments détaillés en relation avec la figure 2, le dispositif 2 comprend une électrode basse 21 et une matrice isolante 26 autour de l'élément chauffant 24.

En figure 6 est représenté le dispositif 2 après l'étape d'initialisation, comprenant un volume 31 dans la couche PCM 25 et un volume 29 dans la couche GeN 27 représentant la partie du matériau à changement de phase présent dans le filament.

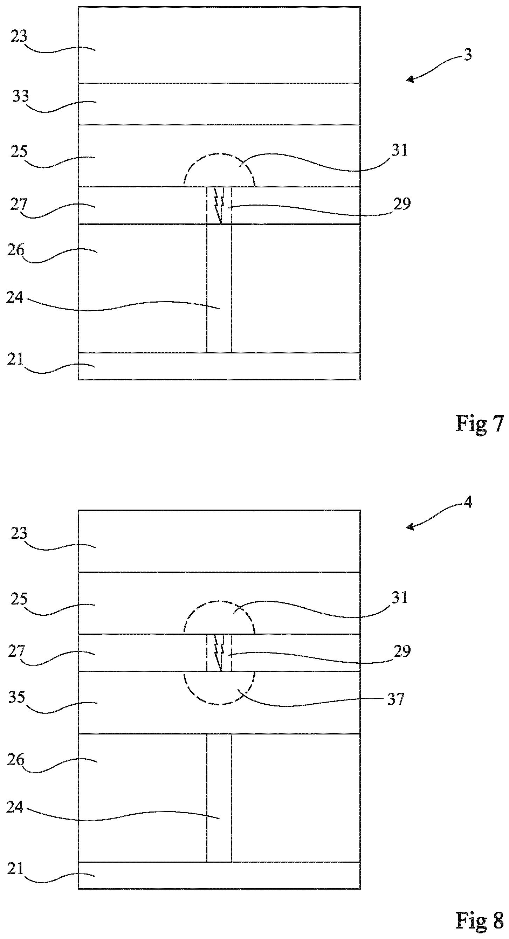

La figure 7 est une vue en coupe d'une variante de réalisation du dispositif illustré en figure 6.

Plus particulièrement, la figure 7 illustre un dispositif 3 similaire au dispositif 2 illustré en figure 6 à la différence près que le dispositif 3 comprend une couche 33 entre l'électrode 23 et la couche PCM 25 du matériau à changement de phase.

Selon le mode de réalisation illustré en figure 7, la couche 33 est composée d'un matériau à base de nitrure de germanium. Le matériau composant la couche 33 a, par exemple, un pourcentage en azote plus élevé que le pourcentage en azote du matériau composant la couche GeN 27 afin d'augmenter la stabilité thermique du dispositif 3. La couche 33 est, par exemple, constituée uniquement de nitrure de germanium dopé ou non dopé similairement à la couche GeN 27. Le pourcentage en azote du matériau de la couche 33 est, par exemple, supérieur à 35 %, et selon un mode de réalisation, de l'ordre de 45 %. Dans ce cas, la couche 33 ne comprend, par exemple, pas de filament.

Selon le mode de réalisation illustré en figure 7, la surface A permettant de relier le courant et la densité de courant propagés à travers le dispositif 3 est sensiblement identique à la surface A du dispositif 2.

Un avantage qui apparaît avec la présence de la couche 33 entre l'électrode 23 et la couche PCM 25 du matériau à changement de phase est que les pertes thermiques issues de l'interface entre la couche PCM 25 et l'électrode 23 sont réduites et que le confinement thermique est ainsi amélioré.

La figure 8 est une vue en coupe d'une autre variante de réalisation du dispositif illustré en figure 6.

Plus particulièrement, la figure 8 illustre un dispositif 4 similaire au dispositif 2 illustré en figure 6 à la différence près que le dispositif 4 comprend une couche 35 entre la couche GeN 27 et l'électrode 21 ou, si le dispositif comprend un élément chauffant 24, entre la couche GeN 27 et l'élément chauffant 24.

Selon le mode de réalisation illustré en figure 8, la couche 35 est composée d'un matériau à changement de phase, par exemple, de même nature que celui de la couche PCM 25.

Selon le mode de réalisation illustré en figure 8, lorsque le courant augmente à travers le dispositif 4, la densité de courant qui traverse le volume 29 devient très importante en comparaison à la densité de courant qui traverse le reste du dispositif 4 du fait de la faible largeur du filament 29. Lorsque la densité de courant traverse le volume 29, cela provoque un point chaud au sein du volume 29. Le matériau à changement de phase autour du point chaud, c'est-à-dire le matériau à changement de phase dans les volumes 29 et 31 et un volume 37 de la couche 35 changent alors d'état résistif.

Le volume 37 a la forme d'un dôme renversé c'est-à-dire que sa base est à l'interface entre la couche GeN 27 et la couche 35.

Le dispositif 4 comprend, ainsi, lors de l'augmentation de la température, deux dômes en symétrie axiale, c'est-à-dire que leurs faces planes, ou bases, se font face.

Le courant et la densité de courant traversant le dispositif 4 sont alors reliés par la surface A, correspondant à l'aire de la section de la zone 29.

Un avantage qui apparaît avec la présence de la couche 35 entre la couche GeN 27 et l'électrode 21 ou l'élément chauffant 24 est que les pertes thermiques issues de l'interface entre la couche GeN 27 et l'électrode 21 ou l'élément 24 sont diminuées grâce à la faible conductivité thermique du matériau de la couche 35.

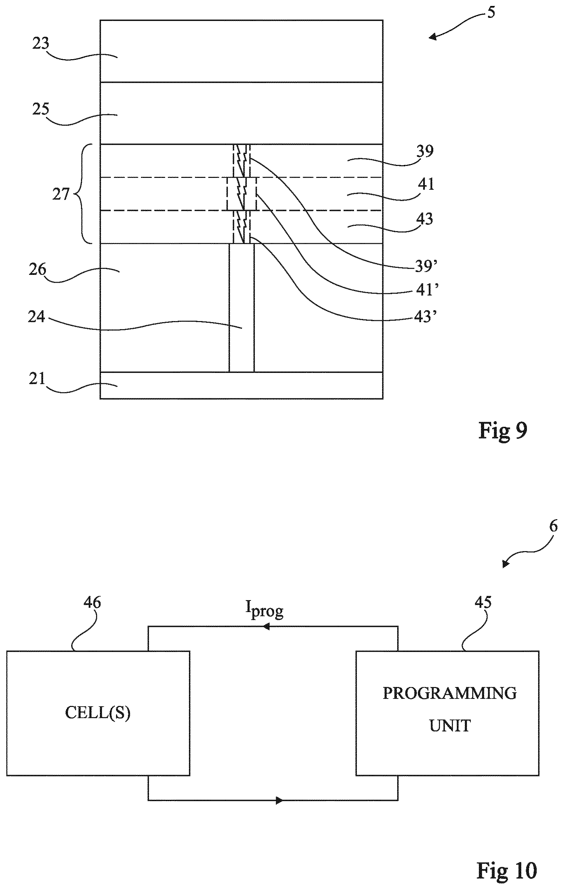

La figure 9 est une vue en coupe d'encore une autre variante de réalisation du dispositif illustré en figure 6.

Plus particulièrement, la figure 9 illustre un dispositif 5 similaire au dispositif 2 illustré en figure 6 à la différence près que la couche GeN 27 du dispositif 5 comprend plusieurs sous-couches à base de nitrure de germanium dans lesquelles le pourcentage d'azote varie d'une des sous-couches par rapport aux autres. Par exemple, les sous-couches de la couche GeN 27 comprennent uniquement du nitrure de germanium dopé ou non dopé similairement à la couche GeN 27, telle que décrit en relation avec la figure 8. Le pourcentage d'azote dans chacune des sous-couches de la couche 27 peut, à titre d'exemple, être inférieur à 25 % ou être supérieur à 35 %. Toutefois, le pourcentage moyen des pourcentages d'azote de toutes les sous-couches de la couche 27 peut être compris avantageusement entre 25 % et 35 %.

Selon le mode de réalisation illustré en figure 9, la couche GeN 27 comprend trois sous-couches 39, 41, 43. Toutefois, le nombre de sous-couches peut être de deux ou être supérieur à trois.

Selon le mode de réalisation illustré en figure 9, la sous-couche 39 correspond à la sous-couche supérieure de la couche GeN 27, c'est-à-dire la sous-couche en contact avec la face inférieure de la couche PCM 25. Selon ce même mode de réalisation, la sous-couche 43 correspond à la sous-couche inférieure de la couche GeN 27, c'est-à-dire à la sous-couche en contact avec la face supérieure de l'électrode 21 ou, le cas échéant, la face supérieure de l'élément chauffant 24. En outre, la sous-couche 41 correspond à la couche intermédiaire de la couche GeN 27, c'est-à-dire qu'elle est située entre la sous-couche 39 et la sous-couche 43.

Selon le mode de réalisation illustré en figure 9, le pourcentage en azote de la sous-couche 41 est supérieur au pourcentage en azote des sous-couches 43 et 39.

Selon le mode de réalisation illustré en figure 9, la couche 39 comprend un filament 39', la couche 41 comprend un filament 41' et la couche 43 comprend un filament 43'. Le filament 41' a, en figure 9, une largeur plus importante que la largeur des filaments 39' et 43'

Un avantage qui apparaît avec la superposition de plusieurs couches de nitrure de germanium comprenant des pourcentages d'azote différents les uns des autres du présent mode de réalisation est que la surface A, qui correspond à la zone de contact entre le filament 43' de la couche 43 et l'électrode 21 ou l'élément 24, est mieux contrôlée.

Un avantage que les sous-couches de la couche 27 soient organisées de sorte que la sous-couche ayant le pourcentage en azote le plus élevé recouvre et soit recouverte par des sous-couches ayant un pourcentage en azote plus faible est d'augmenter l'isolation thermique autour du point chaud et ainsi réduire les pertes thermiques et diminuer la densité de courant nécessaire au changement de phase.

Dans un autre mode de réalisation, le pourcentage en azote des sous-couches 39, 41 et 43 peut être croissant, c'est-à-dire que le pourcentage en azote est plus important dans la sous-couche 43 que dans la sous-couche 39.

La figure 10 est un schéma bloc illustrant un système 6 de mémoire à changement de phase.

Plus particulièrement, le système 6 comprend une unité de programmation (PROGRAMMING UNIT) 45 et une matrice 46 d'une ou plusieurs cellules (CELL(S)).

Chaque cellule de la matrice 46 comprend un dispositif tel qu'illustré en figures 2, 6, 7, 8 ou 9.

Selon le mode de réalisation illustré en figure 10, l'unité de programmation 45 génère un courant $I_{prog}$ qui passe dans chaque cellule de la matrice 46. Au sein de chaque cellule, le dispositif est traversé par une densité de courant $J_{prog}$, correspondant au courant $I_{prog}$ divisé par la surface **A.**

Selon un mode de réalisation, l'évolution de la densité de courant propagée dans les dispositifs 2, 3 et 4 en fonction du temps afin de basculer le volume 31 dans un état moins résistif (opération SET) comprend :

une étape d'augmentation de la densité de courant en fonction du temps afin de rendre le matériau du volume 31 conducteur ; et

une étape de diminution monotone de la densité de courant en fonction du temps afin de basculer le matériau du volume 31 dans un état moins résistif.

Dans certains modes de réalisation, cette diminution monotone correspond à une décroissance linéaire. Toutefois, cette forme de décroissance peut conduire à des opérations relativement longues.

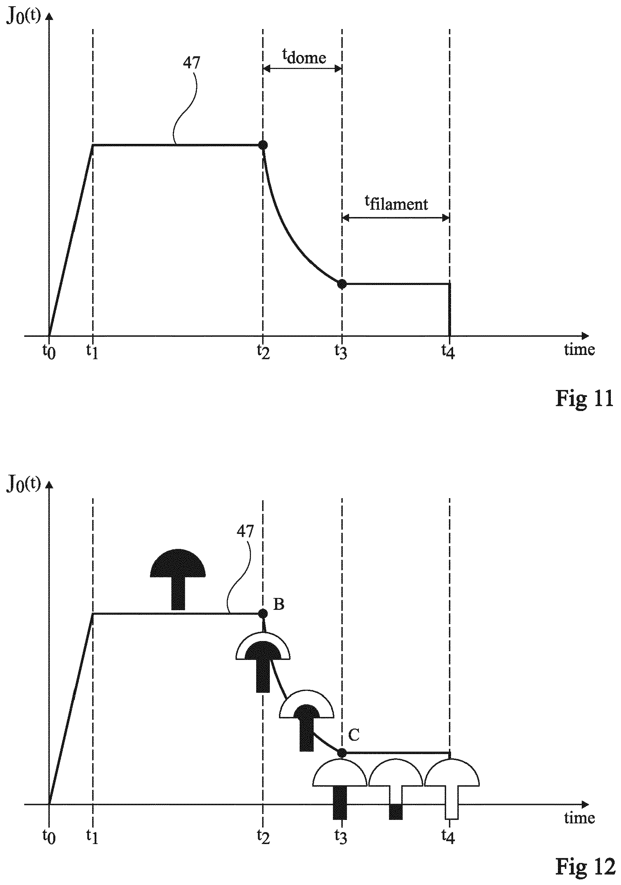

Une autre forme de décroissance permettant une augmentation de la vitesse de programmation est décrite en relation avec les figures 11 à 15.

La figure 11 représente un mode de réalisation de l'évolution de la densité de courant propagée dans les dispositifs 2 à 5 illustrés en figures 2 et 6 à 9 en fonction du temps afin de basculer une partie des matériaux de ces dispositifs dans un état moins résistif. L'évolution de la densité de courant propagée dans les dispositifs 2 à 5 afin de faire basculer une partie des matériaux de ces dispositifs dans un état faiblement résistif ne se limite pas aux modes de réalisations décrits ci après.

Plus particulièrement, la figure 11 représente une courbe 47 illustrant l'évolution de la densité surfacique de courant $J_0(t)$, imposée par un courant $I(t)$ passant par les électrodes en fonction du temps (time).

Selon le mode de réalisation illustré en figure 11, la courbe 47 comprend :

une première portion de croissance linéaire de la densité de courant entre un instant $t_0$ et un instant $t_1$ ;

une deuxième portion de densité de courant sensiblement constante entre l'instant $t_1$ et un instant $t_2$ ;

une troisième portion de décroissance non linéaire de la densité de courant entre l'instant $t_2$ et un instant $t_3$,

la durée entre les instants $t_2$ et $t_3$ étant nommée $t_{dome}$ ; et

une quatrième portion de densité de courant sensiblement constant entre l'instant $t_3$ et un instant $t_4$, la durée entre les instants $t_3$ et $t_4$ étant nommée $t_{filament}$.

La figure 12 représente la même courbe 47 que la figure 11 et montre en outre l'évolution structurelle du basculement, dans les volumes 31 et 29 (figures 2, 6 à 8), de matériau à changement de phase dans un état moins résistif.

A l'instant $t_0$, le matériau à changement de phase du volume 31 est résistif et la densité de courant est, par exemple à un niveau 0. Entre les instants $t_0$ et $t_1$, la densité de courant augmente de façon à atteindre, à l'instant $t_1$, une valeur en densité de courant qui restera sensiblement constante jusqu'à l'instant $t_2$ (point B). Entre les instants $t_0$ et $t_2$, le matériau à changement de phase des volumes 29 et 31 devient conducteur après l'initialisation.

Entre l'instant $t_2$ et l'instant $t_3$, pendant la durée $t_{dome}$, le matériau à changement de phase du volume 31, en particulier le dôme correspondant au volume 31, passe dans un état moins résistif. Ce passage du volume 31 dans un état moins résistif s'effectue à partir de l'extérieur du volume 31 vers l'intérieur du volume 31, c'est-à-dire à partir de la face bombée du dôme vers la face plane de celui-ci.

Lors de cette étape, un volume 37 bascule dans un état moins résistif également si le dispositif comprend une couche 35 telle qu'illustrée en figure 8.

Lors de la durée $t_{dome}$, la courbe 47 décroit, c'est-à-dire que la densité de courant diminue en fonction du temps. La courbe 47 lors de cette durée $t_{dome}$ suit la fonction :

[Math 2]

$$J_0(t) = \frac{1}{\sqrt{Ht}}$$

La valeur H est définie, par exemple, par la formule :

[Math 3]

$$H = \frac{v_g . R_{th} . A^2 . R_h}{h . (T_{melt} - T_h)}$$

dans laquelle : $v_g$ est la vitesse de cristallisation du matériau à changement de phase, $R_{th}$ est la résistance thermique du dispositif, $R_h$ est la résistance électrique du matériau à changement de phase, $h$ est la hauteur de la couche PCM 25, $T_{melt}$ est la température de fusion du matériau à changement de phase et $T_h$ est la température à l'interface entre la première électrode et la couche PCM 25.

Le passage du dôme 31 dans un état moins résistif est terminé lorsque la densité de courant vérifie, par exemple, la formule :

[Math 4]

$$J_0(t) = \sqrt{\frac{T_{melt}}{R_{th}.A^2.R_h}}$$

Cette densité de courant, est alors atteinte pour un durée $t_{dome}$ égale à :

[Math 5]

$$t_{dome} = \frac{h.(T_{melt}-T_h)}{v_g.T_{melt}}$$

Ainsi $t_{dome}$ est optimisé pour chaque matériau à changement de phase.

A l'instant $t_3$, l'ensemble du matériau de changement de phase présent dans le volume 31 est dans un état faiblement résistif. On note le point C, le point de la courbe 47 à l'instant $t_3$.

Entre les instants $t_3$ et $t_4$, pendant la durée $t_{filament}$, le matériau à changement de phase du volume 29, c'est-à-dire le matériau présent à l'intérieur du filament, bascule dans un état faiblement résistif. Ce basculement du volume 29 s'effectue, par exemple, à partir de la face supérieure de la couche GeN 27, c'est à dire à partir de l'interface entre la couche GeN 27 et la couche PCM 25, vers la face inférieure de la couche GeN 27, c'est-à-dire vers l'interface entre la couche GeN 27 et l'électrode 21 ou l'élément 24.

Lors de la durée $t_{filament}$, selon le mode de réalisation illustré en figures 11 et 12, la courbe 47 est constante. La durée $t_{filament}$ dépend de l'épaisseur e3 de la couche GeN 27 et donc de la hauteur du filament $h_{filament}$ et correspond, par exemple, à :

[Math 6]

$$t_{filament} = \frac{h_{filament}}{v_g}$$

A l'instant $t_4$, le basculement dans un état résistif du matériau à changement de phase des volumes 29 et 31 dans un état faiblement résistif est par exemple fini et la densité de courant diminue. Le dispositif est ainsi prêt pour un nouveau cycle d'écriture.

A titre d'exemple, la durée $t_{dome}$ est comprise entre 1 ns et 1 μs et la durée $t_{filament}$ est comprise entre 1 ns et 10 μs, pour un filament ayant une hauteur compris entre 5 nm et 30 nm.

Un avantage de suivre l'évolution, décrites ci-avant, de la densité de courant en fonction du temps est que cela permet d'assurer une meilleure cristallisation des volumes du matériau à changement de phase, c'est-à-dire que le matériau à changement de phase devient moins résistif dans l'ensemble du volume considéré.

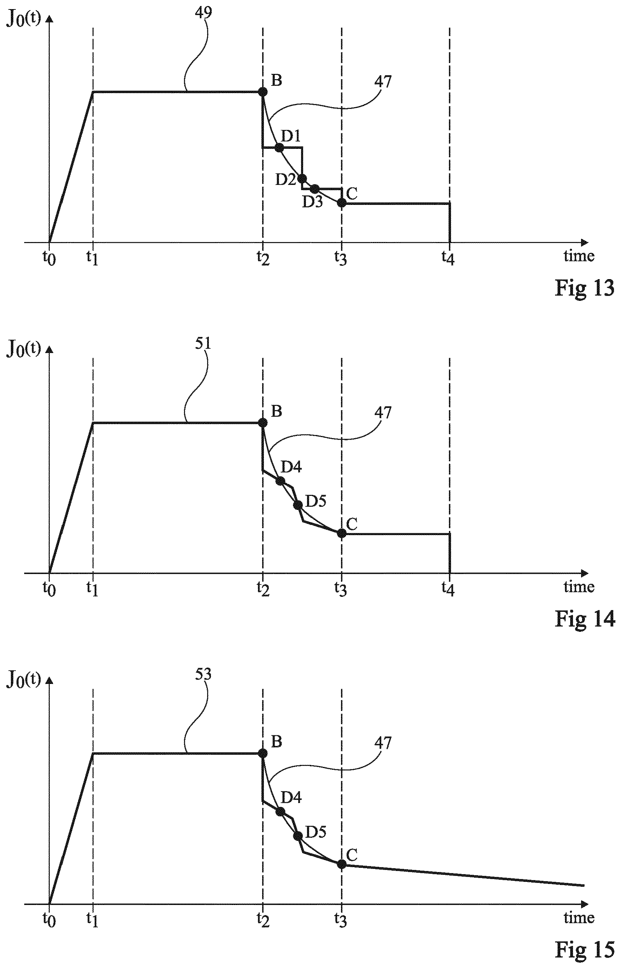

Les figures 13 à 15 représentent d'autres modes de réalisation de l'évolution de la densité de courant propagée dans les dispositifs 2 à 5 illustrés en figures 2, et 6 à 9 en fonction du temps afin de basculer dans un état moins résistif une partie des matériaux de ces dispositifs.

Plus particulièrement, la figure 13 représente une courbe 49 illustrant un mode de réalisation de l'évolution de la densité de courant en fonction du temps similaire à celle illustrée en figures 11 et 12 à la différence près que la courbe 49 représentée en figure 13 est différente de la courbe 47 entre les instants $t_2$ et $t_3$.

Selon le mode de réalisation illustré en figure 13, la courbe 49 passe par les points B et C aux instants $t_2$ et $t_3$. En figure 13, entre les instants $t_2$ et $t_3$, la courbe 49 est segmentée en créneaux décroissants. En d'autres termes, la courbe 49 diminue par paliers entre les instants $t_2$ et $t_3$. La courbe 49 comprend au moins un palier et coupe la courbe 47, en un point D, au moins une fois, en plus des points B et C.

En figure 13, la courbe 49 coupe la courbe 47, entre les points B et C, trois fois aux points D1, D2 et D3. Toutefois selon une variante de réalisation, la courbe 49 peut couper la courbe 47, une fois, deux fois ou plus de trois fois entre les points B et C.

De même, la figure 14 représente une courbe 51 illustrant un mode de réalisation de l'évolution de la densité de courant en fonction du temps similaire à celle illustrée en figures 11 et 12 à la différence près que la courbe 51 représentée en figure 14 est différente de la courbe 47 entre les instants $t_2$ et $t_3$.

Selon le mode de réalisation illustré en figure 14, la courbe 51 passe par les points B et C aux instants $t_2$ et $t_3$. En figure 14, entre les instants $t_2$ et $t_3$, la courbe 51 est segmentée en portions strictement décroissantes et coupe la courbe 47, en un point D, au moins une fois, en plus des points B et C.

En figure 14, la courbe 51 coupe la courbe 47, entre les points B et C, deux fois aux points D4 et D5, toutefois selon une variante de réalisation, la courbe 51 peut couper la courbe 47, entre les points B et C, une fois, ou plus de deux fois.

De même, la figure 15 représente une courbe 53 illustrant un mode de réalisation de l'évolution de la densité de courant en fonction du temps similaire à celle illustrée en figure 14 à la différence près que la courbe 53 représentée en figure 15 est différente de la courbe 51 après l'instant t4.

Selon le mode de réalisation illustré en figure 15, la courbe 53 est décroissante après l'instant $t_4$.

Selon un mode de réalisation, pour chaque instant compris entre $t_2$ et $t_3$, la valeur de la densité de courant de la courbe 47 et la valeur de la densité de courant des courbes 49, 51, 53 sont au maximum différentes de 20 %. En d'autres termes, le rapport entre la valeur de la densité de courant de la courbe 47 sur la différence entre les valeurs des densités de courant des courbes 49, 51 ou 53 est compris entre 0,8 et 1,2.

Un avantage des modes de réalisation et des modes de mise en oeuvre décrits est qu'ils sont compatibles avec les lignes de production usuelles des composants en microélectronique.

Un autre avantage des modes de réalisation et des modes de mise en oeuvre décrits est qu'ils sont compatibles avec les étapes de gravures et de dépouillement (en anglais "stripping").

La figure 16 représente des vues en coupe sous rayons X du dispositif 2 illustré en figure 6.

Plus particulièrement, la figure 16 illustre des vues A1, A2 et A3 du dispositif 2 illustré en figure 6 alors que celui-ci est traversé par un courant ayant une première valeur et des vues B1, B2 et B3 du dispositif 2 illustré en figure 6 alors que celui-ci est traversé par un courant ayant une deuxième valeur, supérieure à la première valeur.

Les vues de la figure 16 mettent en évidence, par une analyse aux rayons X à dispersion d'énergie (EDX, Energy Dispersive X-Ray Analysis) par une microscopie électronique en transmission (TEM, Transmission Electron Microscopy), un à un, les composants de la couche GST 25 et de la couche GeN 27. Les vues A1 et B1 mettent en évidence la présence du germanium au sein des couches 25 et 27, les vues A2 et B2 mettent en évidence la présence de l'antimoine au sein des couches 25 et 27 et les vues A3 et B3 mettent en évidence la présence du tellure au sein des couches 27 et 25.

Lorsque le courant est à la première valeur, le germanium est localisé dans la couche GST 25 et dans la couche GeN 27, l'antimoine est localisé dans la couche 25 et le tellure est localisé dans la couche 25.

Lorsque le courant est à la deuxième valeur, le germanium est localisé dans la couche GST 25 de façon inhomogène puisqu'il est moins présent dans le volume 31. Le germanium est, en outre, localisé dans la couche GeN 27 de façon inhomogène puisqu'il n'est pas présent dans la couche 27 en vis-à-vis du volume 31. L'antimoine est localisé dans la couche GST 25 de façon inhomogène puisqu'il est plus présent dans le volume 31. Le tellure est localisé dans la couche GST 25 de façon inhomogène puisqu'il est moins présent dans le volume 31.

Les inventeurs ont constaté que le phénomène illustré en vues B1, B2 et B3 s'apparente à une fusion des matériaux des couches 25 et 27 au niveau du point chaud (ici le volume 31) et à un mélange de ces couches. Pour un courant moins important, ici illustré en vues A1, A2 et A3, les couches 25 et 27 restent intègrent et ne se mélangent pas. Dans le cas de la première valeur de densité de courant (en relation avec les vues A1, A2 et A3), la couche 27 comprend un canal de matériau à changement de phase, composé de germanium, d'antimoine et de tellure, trop fin pour être visible en vues A1, A2 et A3.

La limite entre ces deux phénomènes est donnée par un courant nommé $I_{lim}$ correspondant, par exemple, au courant de programmation du dispositif 2 si celui-ci n'a pas de couche 27. En d'autres termes, le courant limite correspond au courant nécessaire pour basculer le matériau du volume 31 d'un état résistif à un état moins résistif dans le cas où le dispositif 2 ne comporte pas de couche GeN 27. Par exemple, le courant est inférieur à 500 μA, et dans certains cas inférieur à 200 μA et par exemple égal à environ 50 μA.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation illustrés en figures 7, 8 et 9 peuvent être combinés.

Enfin, la mise en oeuvre pratique des modes de réalisation et variantes décrits est à la portée de la personne du métier à partir des indications fonctionnelles données ci-dessus.

L'étendue de la protection de la présente invention est définie par le libellé des revendications 1 à 14 annexées.

**Revendications**

1. Dispositif de mémoire à changement de phase (2 ; 3 ; 4 ; 5) comprenant, entre des première (23) et deuxième électrodes (21) :

   une première couche (25) d'un matériau à changement de phase ; et
   une deuxième couche (27) à base de nitrure de germanium, en contact avec la première couche, **caractérisé en ce que** le pourcentage atomique d'azote dans la deuxième couche est compris entre 20 % et 35 %, et la deuxième couche est traversée par un canal du matériau à changement de phase de la première couche.

2. Dispositif selon la revendication 1, dans lequel la première couche (25) comprend une zone (31), en forme de dôme, changeant d'état en fonction de la densité de courant appliquée à travers la première couche.

3. Dispositif selon la revendication 2, dans lequel la largeur du canal est fonction du pourcentage en azote dans la deuxième couche (27).

4. Dispositif selon l'une quelconque des revendications 1 à 3, comprenant une troisième couche (35), d'un matériau à changement de phase, entre la deuxième couche (27) et la deuxième électrode (21).

5. Dispositif selon la revendication 4, dans lequel la troisième couche (35), comprend du germanium, de l'antimoine et du tellure.

6. Dispositif selon la revendication 2 ou 3, dans lequel :

la deuxième électrode (21) est en contact avec la deuxième couche (27) de sorte que le canal est en contact de la deuxième électrode sur une surface (A) déterminée par les dimensions du canal ; ou
un élément chauffant (24) électrode (21) est en contact avec la deuxième couche (27) de sorte que le canal est en contact de l'élément chauffant sur une surface (A) déterminée par les dimensions du canal.

7. Dispositif selon l'une quelconque des revendications 1 à 6, dans lequel le matériau à changement de phase est à base de germanium, d'antimoine et de tellure.

8. Dispositif selon l'une quelconque des revendications 1 à 7, dans lequel la deuxième couche (27) a une épaisseur comprise entre 2 nm et 30 nm, par exemple, comprise entre 3 nm et 25 nm.

9. Dispositif selon l'une quelconque des revendications 1 à 8, comprenant une quatrième couche (33), à base de nitrure de germanium, entre la première électrode (23) et la première couche (25).

10. Dispositif selon l'une quelconque des revendications 1 à 9, dans lequel la deuxième couche (27) comprend plusieurs sous-couches (39, 41, 43), et chaque sous-couche de la deuxième couche a un pourcentage en azote différent des pourcentages en azote des autres sous-couches de la deuxième couche.

11. Dispositif selon la revendication 10, dans lequel la deuxième couche comprend au moins une sous-couche intermédiaire entre deux autres des sous-couches, le pourcentage d'azote de la sous-couche intermédiaire étant supérieur au pourcentage d'azote des autres sous-couches.

12. Système (6) comprenant un ou plusieurs dispositifs selon l'une quelconque des revendications 1 à 11, organisés en matrice, et une unité de programmation (45).

13. Procédé de fabrication d'un dispositif selon l'une quelconque des revendications 1 à 11 comprenant :

la formation de la première et de la deuxième couche ; et
une opération d'initialisation formant le canal dans la deuxième couche.

14. Procédé selon la revendication 13, dans lequel l'étape d'initialisation est réalisée à des intensités de courant comprises entre 1 μA et 1,5 mA, par exemple entre 100 μA et 1,2 mA.

**Patentansprüche**

1. Eine Phasenwechsel-Speichervorrichtung (2; 3; 4; 5) aufweisend, zwischen einer ersten (23) und einer zweiten Elektrode (21):

eine erste Schicht (25) aus einem Phasenwechselmaterial; und
eine zweite Schicht (27) auf Germaniumnitridbasis, die mit der ersten Schicht in Kontakt steht, **dadurch gekennzeichnet, dass** der prozentuale Anteil an atomarem Stickstoff in der zweiten Schicht zwischen 20 % und 35 % liegt und die zweite Schicht einen Kanal aus dem Phasenwechselmaterial der ersten Schicht hat, der durch sie hindurch verläuft.

2. Die Vorrichtung nach Anspruch 1, wobei die erste Schicht (25) einen kuppelförmigen Bereich (31) aufweist, der seinen Zustand in Abhängigkeit von der Stromdichte ändert, die durch die erste Schicht fließt.

3. Die Vorrichtung nach Anspruch 2, wobei die Kanalbreite vom Stickstoffanteil in der zweiten Schicht (27) abhängt.

4. Die Vorrichtung nach einem der Ansprüche 1 bis 3, aufweisend eine dritte Schicht (35) aus einem Phasenwechselmaterial zwischen der zweiten Schicht (27) und der zweiten Elektrode (21).

5. Die Vorrichtung nach Anspruch 4, wobei die dritte Schicht (35) Germanium, Antimon und Tellur aufweist.

6. Die Vorrichtung nach Anspruch 2 oder 3, wobei:

die zweite Elektrode (21) mit der zweiten Schicht (27) in Kontakt steht, so dass der Kanal mit der zweiten Elektrode über einen Bereich (A) in Kontakt steht, der durch die Kanalabmessungen bestimmt wird; oder
eine Heizelektrode (24) (21) mit der zweiten Schicht (27) in Kontakt steht, so dass der Kanal mit der Heizvorrichtung über einen Bereich (A) in Kontakt steht, der durch die Kanalabmessungen bestimmt wird.

7. Die Vorrichtung nach einem der Ansprüche 1 bis 6, wobei das Phasenwechselmaterial auf Germanium, Antimon und Tellur basiert.

**8.** Die Vorrichtung nach einem der Ansprüche 1 bis 7, wobei die zweite Schicht (27) eine Dicke zwischen 2 nm und 30 nm hat, beispielsweise zwischen 3 nm und 25 nm.

**9.** Die Vorrichtung nach einem der Ansprüche 1 bis 8, aufweisend eine vierte Schicht (33) auf Germaniumnitridbasis zwischen der ersten Elektrode (23) und der ersten Schicht (25).

**10.** Die Vorrichtung nach einem der Ansprüche 1 bis 9, wobei die zweite Schicht (27) mehrere Unterschichten (39, 41, 43) aufweist und jede Unterschicht der zweiten Schicht einen prozentualen Stickstoffanteil hat, der sich von den prozentualen Stickstoffanteilen der anderen Unterschichten der zweiten Schicht unterscheidet.

**11.** Die Vorrichtung nach Anspruch 10, wobei die zweite Schicht wenigstens eine Zwischenunterschicht zwischen zwei anderen Unterschichten aufweist, wobei der prozentuale Stickstoffanteil der Zwischenunterschicht größer ist als der prozentuale Stickstoffanteil der anderen Unterschichten.

**12.** Ein System (6) aufweisend eine oder mehrere Vorrichtungen nach einem der Ansprüche 1 bis 11, die in einer Anordnung angeordnet sind, und eine Programmiereinheit (45).

**13.** Ein Verfahren zum Herstellen einer Vorrichtung nach einem der Ansprüche 1 bis 11, das Folgendes aufweist:

Ausbilden der ersten und zweiten Schicht; und Durchführen einer Initialisierungsoperation zum Ausbilden des Kanals in der zweiten Schicht.

**14.** Das Verfahren nach Anspruch 13, wobei der Ausbildungsschritt bei Stromstärken zwischen 1 $\mu$A und 1,5 mA durchgeführt wird, beispielsweise zwischen 100 $\mu$A und 1,2 mA.

**Claims**

**1.** A phase change memory device (2; 3; 4; 5) comprising, between first (23) and second electrodes (21):

a first layer (25) of a phase change material; and a second, germanium nitride-based layer (27), in contact with the first layer, **characterized in that** the atomic nitrogen percentage in the second layer is between 20% and 35% and the second layer has a channel of the phase change material of the first layer passing through it.

**2.** The device according to claim 1, wherein the first layer (25) comprises a dome-shaped region (31), changing state based on the current density passing through the first layer.

**3.** The device according to claim 2, wherein the channel width is based on the nitrogen percentage in the second layer (27).

**4.** The device according to any one of claims 1 to 3, comprising a third layer (35) of a phase change material between the second layer (27) and the second electrode (21).

**5.** The device according to claim 4, wherein the third layer (35) comprises germanium, antimony and tellurium.

**6.** The device according to claim 2 or 3, wherein:

the second electrode (21) is in contact with the second layer (27) such that the channel is in contact with the second electrode over an area (A) determined by the channel dimensions; or
a heater (24) electrode (21) is in contact with the second layer (27) such that the channel is in contact with the heater over an area (A) determined by the channel dimensions.

**7.** The device according to any one of claims 1 to 6, wherein the phase change material is based on germanium, antimony and tellurium.

**8.** The device according to any one of claims 1 to 7, wherein the second layer (27) has a thickness of between 2 nm and 30 nm, such as between 3 nm and 25 nm.

**9.** The device according to any one of claims 1 to 8, comprising a fourth germanium nitride-based layer (33) between the first electrode (23) and the first layer (25).

**10.** The device according to any one of claims 1 to 9, wherein the second layer (27) comprises a plurality of sublayers (39, 41, 43), and each sublayer of the second layer has a nitrogen percentage different from the nitrogen percentages of the other sublayers of the second layer.

**11.** The device according to claim 10, wherein the second layer comprises at least one intermediate sublayer between two other sublayers, the nitrogen percentage of the intermediate sublayer being greater than the nitrogen percentage of the other sublayers.

**12.** A system (6) comprising one or more devices according to any of claims 1 to 11, organized in an array, and a programming unit (45).

13. A method for manufacturing a device according to any one of claims 1 to 11 comprising:

forming the first and second layers; and performing an initialization operation to form the channel in the second layer.

14. The method according to claim 13, wherein the forming step is performed at current intensities of between 1 $\mu$A and 1.5 mA, such as between 100 $\mu$A and 1.2 mA.

Fig 1

Fig 2

Fig 3

Fig 4

Fig 5

Fig 6

Fig 7

Fig 8

23

25

27 {

39

41

43

39'

41'

43'

26

24

21

5

**Fig 9**

6

46

45

$I_{prog}$

CELL(S)

PROGRAMMING

UNIT

**Fig 10**

Fig 11

Fig 12

Fig 13

Fig 14

Fig 15

A1.

A2.

A3.

B1.

B2.

B3.

Fig 16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2007200108 A

- CN 101101961

### Littérature non-brevet citée dans la description

- Unveiling the structural origin to control resistance drift in phase-change memory materials. **ZHANG WEI et al.** MATERIALS TODAY. ELSEVIER, 13 August 2020, vol. 41, 156-176